Europäisches Patentamt

European Patent Office

Office européen des brevets

(19)

(11) Publication number: **0 243 705**

**A1**

(12) **EUROPEAN PATENT APPLICATION**

(21) Application number: **87104789.0**

(51) Int. Cl.⁴: **G01R 31/02**

(22) Date of filing: **01.04.87**

A request for addition of figures 3, 4 and 5 has been filed pursuant to Rule 88 EPC. A decision on the request will be taken during the proceedings before the Examining Division (Guidelines for Examination in the EPO, A-V, 2.2).

(30) Priority: **02.04.86 IT 2139486 U**

(43) Date of publication of application:
**04.11.87 Bulletin 87/45**

(84) Designated Contracting States:
**AT BE CH DE ES FR GB GR IT LI LU NL SE**

(71) Applicant: **Stabile, Aldo**
**Via Caterina degli Uberti, 2**
**I-26013 Crema(IT)**

(72) Inventor: **Stabile, Aldo**
**Via Caterina degli Uberti, 2**
**I-26013 Crema(IT)**

(74) Representative: **Dr. Ing. A. Racheli & C.**
**Viale San Michele del Carso, 4**
**I-20144 Milano(IT)**

(54) **A connecting device for easily locating a short circuit between two terminals of a printed circuit.**

(57) The proposed device comprises an insulated electric wire (1) provided at one end with a known connection to the power supply, while the other end is provided with a head (3) carrying at least one plug (4, 4a), said head (3) being connected to at least an elastic means (5, 5') the other end of which is connected to a hook (6, 6') capable of being fastened to the edge of the printed circuit's plate (10).

In particular the elastic means is a spiral spring (5, 5') having one end engaged in the head (3) and the other end engaged to the body of the hook (6, 6').

The electric wire (1) preferably passes through the spring (5).

EP 0 243 705 A1

FIG. 1

## "A CONNECTING DEVICE FOR EASILY LOCATING A SHORT CIRCUIT BETWEEN TWO TERMINALS OF A PRINTED CIRCUIT"

This invention refers to a connecting device which facilitates the locating of an unwanted short circuit in a printed circuit.

As known, printed circuits often have unwanted short circuits that are difficult to locate because of the high number of connections existing on each plate.

These short circuits can be detected by means of a processor which indicates the terminals in which the undesired connection takes place. A power supply is then applied to these terminals while an observer looks at the printed circuit plate through a temperature-sensitive liquid cristal sheet which contacts said plate.

To provide the electric connection of these terminals with the power supply is quite a problem. In fact, the terminals on the plate normally consist of holes having different and very reduced diameters, for instance between 0,3 and 1 mm. Furthermore these holes are fragile; a spring pin compensating the diameter differences cannot be inserted in said holes without damaging them.

Therefore an object of this invention is that to simplify the feeding of short circuit terminals of a printed circuit plate, thus making the use of modern searching machinery fast and advantageous.

The above mentioned object is reached by providing a device made of an insulated electric wire, provided at one end with a connection to a power supply while at the other end a head carrying at least one plug is foreseen, said head being connected to at least one end of at least an elastic means the other end of which is connected to a hook capable of being fastened to the edge of the printed circuit plate.

Two opposed elastic means are preferably foreseen each one being fixed at two opposed areas of said head.

The elastic means is preferably a spring, the electric wire passing trough one of said springs.

Furthermore, the head can be foreseen having two or more plugs. The plugs can be placed on two or more faces of the head if this has a polygonal section.

Furthermore the plugs have preferably different diameters thus mating with the holes of the printed circuit plate.

Particularly, the plugs diameter is always smaller than the diameter of the hole in which they have to enter so that they never force it. The elastic means secure the contact by maintaining the plug in the hole forming the terminal.

Particularly, each one of the two opposed areas of the head are engaged by the end of a spiral spring, said spring having the other end engaged to the body of the hook that fixes the device to the plate.

In this case said hook can be provided, in one of its lower parts with a notch to receive the plate's edge and, in its middle part, with a recess wherein the insulated electric wire can slide after having passed through the spiral spring's central hole.

The device is used as follows: to connect a power supply to a plate's terminal an end of the electric wire is connected to it, then a plate's edge is inserted in one notch and the elastic means connected to said hook is stretched until the head carrying the plug reaches a terminal of the short circuit to be eliminated, the plug is inserted in said terminal and the second elastic means, if present, is stretched until the second notch has received the plate's edge opposed to the first one. In this way, due to the hooks and to the springs tension the plug remains anchored to the plate that can be turned and handled; at the same time, a good connection to the terminal is obtained. The same procedure is carried out for the second terminal so that the plate is ready for the short circuit detection.

The invention will be now better explained with an exemplary embodiment that is shown in the enclosed drawings in which:

Figure 1 is a side view of the whole device;

Figure 2 is a partial top view of the device shown in Figure 1;

Figure 3 shows the enlarged and open details of the head and hook being part of this device;

Figure 4 is a view of the plug and wire connection;

Figures 5 and 6 show a possible way of utilizing the device.

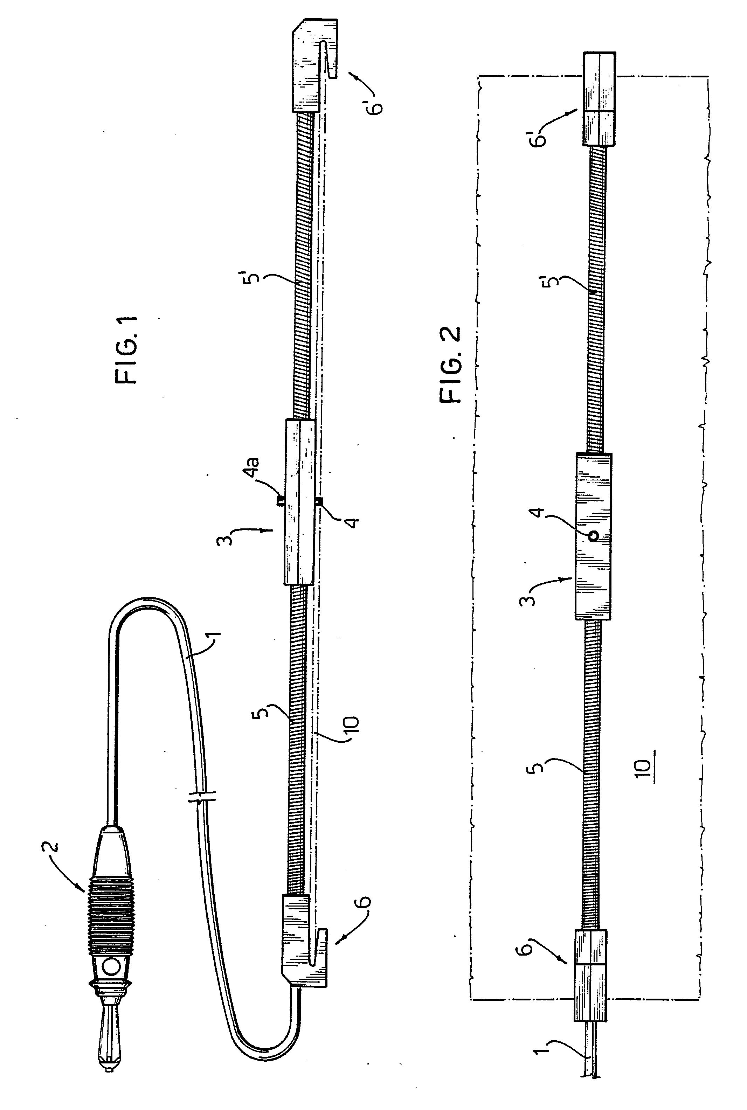

Figures 1 and 2 show an electric wire 1 with an insulating sheath, a known type of pole shoe connection 2 to connect an end of the wire to the power supply, a head 3, two hooks 6 and 6' one at least being hollow and two elastic means 5 and 5'. The wire 1 extends inside spring 5 until reaching plugs 4 and 4a that have different diameters and protrude from head 3; the head side opposite to that connected to spring 5 is connected to spring 5'. The position of printed circuit plate 10 has been indicated with a dotted line; notches 6b of hooks 6 and 6' are fixed on two of said plate's opposed edges. Therefore head 3 is fixed by means of springs 5 and 5' that exert two opposed forces preventing any dispalacement.

Figures 3 and 4 show in detail the fixing of elastic means 5 inserted in recesses 6a and 3a respectively of hook 6 and head 3. Said fixing is similar to that of spring 5' in hook 6' and head 3. Inside spring 5 the insertion of the electric wire 1 in through hole 6c is also foreseen. Then wire 1 is welded to a block 8 ending with two plugs 4 and 4a (figure 4).

Figures 5 and 6 show a possible and advantageous way of using the device. The device can be placed on plate 10's front or rear side. In this way the temperature sensitive sheets 11 and 12 can adhere on both sides of plate 10. Said sheets 11 and 12 become more intensively coloured along the heated circuits thus making clear the position of the short circuit.

From figure 5 it is visible that one of the proposed devices, indicated with A, is placed above the plate while the other device, indicated with B, is placed below it. In this way sheet 11 can completely adhere to all of the plate's surface starting from the position next to device A. Viceversa on the back face of plate 10 sheet 12 is placed with an edge next to device B; said sheet can thus contact all the plate's surface that on the other side was adjacent to device A.

The plate can be turned over several times without the connecting devices being disconnected.

## Claims

1. A device for locating a short circuit between two terminals of a printed circuit (10), characterized in that it comprises an insulated electric wire (1) provided at one end with a known connection to the power supply while the other end is provided with a head (3) carrying at least one plug (4, 4a), said head (3) being connected to at least an elastic means (5, 5') the other end of which is connected to a hook (6, 6') capable of being fastened to the edge of the printed circuit's plate (10).

2. Device as in claim 1, characterized in that the elastic means (5, 5') and the hooks (6, 6') are two and opposed.

3. Device as in claims 1 or 2, characterized in that the elastic means is a spiral spring (5, 5') having one end engaged in the head (3) and the other end engaged to the body of the hook (6, 6').

4. Device as in claim 3, characterized in that the electric wire (1) passes trough the spring (5).

5. Device as in any of the previous claims, characterized in that the head (3) has two or more plugs (4, 4a).

6. Device as in claim 5, characterized in that the head has a polygonal section and that the plugs (4, 4a) are placed on two or more of its faces.

7. Device as in claims 5 or 6, characterized in that the plugs (4, 4a) have different diameters thus mating with the holes forming said plate's (10) circuit terminals.

8. Device as in any of the previous claims, characterized in that the plugs diameter is always smaller than the diameter of the hole forming the terminal wherein the plugs (4, 4a) must enter without forcing it.

9. Device as in any of the previous claims, characterized in that the hook or hooks (6, 6') are provided with a notch (6b) to receive the edge of plate (10).

10. Device as in any of the previous claims, characterized in that the middle part of a hook (6, 6') is provided with a through hole (6c) wherein the insulated electric wire (1) can slide, said electric wire passing through the central hole of the spiral spring (5) thus reaching said through hole (6c).

FIG. 1

FIG. 2

0 243 705

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-3 501 698 (BENDIX CORP.)<br>* Column 5, lines 9-54; figures 1,3,5 * | 1-10 | G 01 R 31/02 |
| | --- | | |
| A | IBM TECHNICAL DISCLOSURE BULLETIN, vol. 18, no. 4, September 1975, page 1132, New York, US; R.A. STOPPENHAGEN: "Card bugging or probe aid"<br>* Page 1132, figure * | 1-10 | |
| | --- | | |
| A | IBM TECHNICAL DISCLOSURE BULLETIN, vol. 25, no. 11A, April 1983, pages 5690-5692, New York, US; R.L. KOFIRA et al.: "Micro-circuit probing system"<br>* Figures 1,2 * | | |
| | ----- | | |

**TECHNICAL FIELDS SEARCHED (Int. Cl.4)**

G 01 R 31/00
G 01 R 1/00
G 05 K 13/00
H 01 R 23/00
H 01 R 11/00

The present search report has been drawn up for all claims

| Place of search | Date of completion of the search | Examiner |
|---|---|---|
| THE HAGUE | 03-07-1987 | CERIBELLA G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82